# EUROPÄISCHE PATENTSCHRIFT

(11) **EP 2 535 927 B1**
(45) Veröffentlichungstag und Bekanntmachung des Hinweises auf die Patenterteilung: **17.08.2016**
(21) Anmeldenummer: 12156797.8
(22) Anmeldetag: 24.02.2012
(51) Int. Cl.: H01L 23/24, G01L 19/14, G01L 19/00, G01L 19/06, C08L 83/04, H01L 23/29, H01L 21/56, B81B 7/00, C08K 3/00

(54) **Abdeckmaterial für einen Mikrochip, Mikrochip mit Abdeckmaterial sowie Verfahren zur Bereitstellung eines solchen Mikrochips**
Covering material for a microchip, microchip with covering material and method for producing such a microchip
Matériau de recouvrement pour une micropuce, micropuce dotée d'un matériau de recouvrement ainsi que procédé de préparation d'une telle micropuce

(30) Priorität: 17.06.2011 DE 102011077684
(43) Veröffentlichungstag der Anmeldung: 19.12.2012
(73) Patentinhaber: Robert Bosch GmbH, 70442 Stuttgart (DE)
(72) Erfinder: Mueller, Roland, 71711 Steinheim (DE); Lang, Tobias, 70197 Stuttgart (DE)

(56) Entgegenhaltungen:
- EP-A1- 0 789 057
- EP-A1- 2 141 201
- EP-A2- 0 821 038
- DE-A1-102004 028 888
- US-A1- 2010 236 689

## Beschreibung

### Stand der Technik

Die Erfindung geht aus von einem Abdeckmaterial für einen Mikrochip nach der Gattung des Anspruchs 1. Ferner geht die Erfindung aus von einem Mikrochip, welcher mit einem Abdeckmaterial bedeckt ist. Schließlich betrifft die Erfindung ein Verfahren zur Bereitstellung eines mit einem Abdeckmaterial bedeckten Mikrochips.

Bei dem vorgenannten Abdeckmaterial für einen Mikrochip kann es sich insbesondere um ein Abdeckmaterial auf Basis von Gel, vorzugsweise auf Basis von Silikon-Gel handeln, ohne jedoch das Abdeckmaterial auf solche Komponenten zu beschränken. Bei einem genannten Mikrochip kann es sich insbesondere um einen Silizium-Mikrochip handeln. Ferner umfasst der verwendete Begriff "Mikrochip" ausdrücklich auch Bauteile, welche wahlweise auch als Teil eines Mikrochips aufgefasst werden könnten. Hierunter fallen unter anderem ein Sensor, insbesondere ein Drucksensor, eine Auswerteschaltung, ein Datenspeicher, ein Sensorelement, eine Messmembran eines Sensors oder eine Messmembran, usw.

Abdeckmaterialien für einen Mikrochip, nämlich insbesondere zum Schutz des Mikrochips, sowie mit solchen Abdeckmaterialien bedeckte Mikrochips sind aus dem Stand der Technik bekannt. So zeigt die DE 100 54 013 B4 ein Drucksensormodul mit einem Drucksensor, wobei der Drucksensor durch ein hierauf aufgebrachtes Abdeckmaterial geschützt ist. Das Abdeckmaterial kann dabei ein medienresistentes Gel, wie z.B. ein Fluor-Silikon-Gel aufweisen. Bekannte Abdeckmaterialien für einen Mikrochip können dabei in einem gewissen Umfang einen Schutz des hiermit bedeckten Mikrochips bzw. von hiermit bedeckten Teilen eines Mikrochips vor mechanischen Einwirkungen und/oder aggressiven Medien bereitstellen. Entsprechende, aus dem Stand der Technik bekannte Mikrochips, welche mit einem solchen Abdeckmaterial bedeckt sind, können in entsprechender Weise einen Schutz vor solcherlei Einwirkungen aufweisen. Insbesondere lassen sich mit geeigneten Abdeckmaterialien Bonddrähte von Mikrochips vor Beschädigung schützen.

Bekannte Mikrochips, beispielsweise Drucksensoren, sind für den Anwendungsfall oftmals in einem Gehäuse angeordnet und hierzu lösbar oder unlösbar mit dem Gehäuse verbunden. Solche Gehäuse oder entsprechende Gehäuseteile sind dabei verbreitet aus Kunststoffmaterial gefertigt.

Des Weiteren tritt verbreitet der Fall ein, dass Mikrochips - ob diese ihrerseits in einem eigenen Gehäuseteil aufgenommen sind oder nicht- in ein weiteres Gehäuse verbaut werden, um die gewünschte Auslegung und Einsatzfähigkeit herzustellen.

Oftmals müssen dabei verschiedene Gehäuseteile, von denen zumindest eines einen genannten Mikrochip aufweist, miteinander verbunden werden. Im Falle einer nachfolgenden Klebeverbindung von Kunststoffteilen ist es dabei vorteilhaft oder sogar zwingend nötig, zumindest das Gehäuseteil des Mikrochips vorhergehend zu aktivieren, nämlich insbesondere durch eine Plasmabehandlung, um die hinreichende Qualität einer nachfolgend hergestellten Klebeverbindung sicherzustellen.

Alternativ oder zusätzlich sind Klebeverbindungen von Gehäuseteilen denkbar, bei denen eine Vernetzung des Klebstoffs durch eine Beaufschlagung mit ultravioletter (UV-) Strahlung zu erfolgen hat, um eine schnelle und sichere Fixierung der Fügepartner und kurze Taktzeiten zu ermöglichen.

Neben Klebeverfahren zur Festlegung eines genannten Mikrochips an einem Gehäuseteil oder zur Verbindung solcher Gehäuseteile, wobei zumindest eines dieser Teile einen Mikrochip beinhaltet, sind auch Schweißverfahren denkbar.

Sämtliche der oben beschriebenen, lediglich beispielhaft und nicht abschließend aufgezählten Fügeverfahren sind jedoch hinsichtlich ihres Potentials einer negativen Einwirkung auf dadurch mittelbar und unmittelbar festgelegte Mikrochips nachteilig. So kann bei sämtlichen der aufgezählten Techniken zur Verbindung von Teilen UV-Strahlung entstehen, welche bis auf den zu befestigenden Mikrochip vordringend kann. Der Einfluss von UV-Strahlung auf Mikrochips ist jedoch unerwünscht und kann zu nachteiligen Veränderungen des Mikrochips führen. Beispielsweise ist es bei Eprom-, EEprom-, OTP-(one time programmable) oder auch anderen Speicherzellentypen möglich, dass Ladungen aufgrund der Einreichung von UV-Strahlung abfließen und so die gespeicherte Information verfälscht wird oder verloren geht.

Andererseits ist eine Abschirmung von Mikrochips vor einer unerwünschten Einwirkung von UV-Strahlung aus konstruktiver Hinsicht nicht immer möglich oder sehr aufwendig. Aus dem Stand der Technik bekannte Abdeckmaterialien für Mikrochips stellen keinen zureichenden Schutz für diesen Fall bereit. Dementsprechend weisen bekannte Mikrochips, welche mit einem bekannten Abdeckmaterial bedeckt sind, einen nicht hinlänglichen Schutz vor solchen nachteiligen Einwirkungen auf.

Aus der US 2010/0236689 A1 ist eine Klebefolie zum Herstellen einer Halbleitervorrichtung bekannt, bei der die Klebeschicht verwendet wird, um einen Halbleiterchip auf einen Wafer zu kleben. Die Klebeschicht weist eine Pigmentierung auf, um bei der Herstellung der Halbleitervorrichtung die genaue Position der Klebeschicht mittels Licht zu erfassen.

Aus der EP 0 821 038 A2 ist ein Herstellungsverfahren von Elektronikbauteilen bekannt, bei dem ein Halbleiterelement auf einer Leiterplatte mittels eines Klebemittels angebracht wird und von mehreren Schichten eines Harzes bedeckt wird, die teilweise zur Aushärtung einer UV-Bestrahlung unterzogen werden.

Die EP 0 789 057 A1 beschreibt aushärtbare Kunstharzschichten zum Abdecken von Elektronikbauteilen, wie Halbleiterelementen, die von einer UV-aushärtbaren Kunstharzschicht bedeckt werden.

Aus der DE 10 2004 028 888 A1 ist ein elektronisches Bauteil bekannt, bei dem eine Schaltung zum Schutz vor Umwelteinflüssen mit einer Gelschicht versehen ist.

Aus der EP 2 141 201 A1 ist ein Epoxidharzmaterial zur Herstellung von Gehäusefassungen für LEDs und Solarzellen bekannt, das beständig gegen UV-Strahlen ausgebildet ist.

### Offenbarung der Erfindung

Es werden daher ein Abdeckmaterial für einen Mikrochip sowie ein Mikrochip, welcher mit einem Abdeckmaterial bedeckt ist, vorgeschlagen, welche die oben genannten Nachteile vermeiden und einen verbesserten Schutz eines Mikrochips vor nachteiligen Einwirkungen bereitstellen bzw. aufweisen.

Demgemäß ist mit einem erfindungsgemäßen Abdeckmaterial mit den Merkmalen des Anspruchs 1 ein verbesserter Schutz eines Mikrochips vor nachteiligen Einwirkungen bereitstellbar. Dazu weist das erfindungsgemäße Abdeckmaterial zumindest eine Schutzkomponente auf, welche einen Schutz eines mit dem Abdeckmaterial bedeckten Mikrochips vor der Einwirkung von UV-Strahlung bereitstellt, wobei die Schutzkomponente als organischen Filter ein Salicylsäureester aufweist und/oder ein Pigment, das Titandioxid und/oder Zinkoxid ist.

Vorteilhafte Ausgestaltungen und Weiterbildungen des Abdeckmaterials ergeben sich aus den hierzu nachgeordneten Ansprüchen.

Um schädlichen Einflüssen von unerwünscht auf einen Mikrochip einwirkender UV-Strahlung entgegenzuwirken, ist das Abdeckmaterial in erfindungsgemäßer Weise durch zumindest eine Schutzkomponente modifiziert, welche das Vordringen schädlicher UV-Strahlung bis zu einem darunter liegenden Mikrochip verhindert oder zumindest bis auf einen unbedenklichen oder nicht schädlichen Anteil unterdrückt. Mit Hilfe der vorliegenden Erfindung können nunmehr auch UV-empfindliche Mikrochips Folgeprozessen ausgesetzt werden, in denen potenziell oder sicher eine Beaufschlagung mit UV-Strahlung auftritt. Darunter fallen insbesondere Plasmabehandlungen für nachfolgende Klebeprozesse oder Klebeprozesse mit einer vorhergehenden Aktivierung der Fügepartner mittels UV-Strahlung. Die Verbesserung betrifft dabei sowohl das entsprechende Zusammenfügen von Gehäuseteilen, von denen mindestens eines einen genannten Mikrochip enthält, als auch ganz allgemein das Festlegen eines Mikrochips an einer beliebigen Unterlage oder einem Gehäuseteil, wobei während des Festlegens oder der Vorbereitung hierzu UV-Strahlung auf den Mikrochip einwirken kann. Beispielsweise können nunmehr auch UV-empfindliche Speichertechnologien in Anwendungsspezifischen Integrierten Schaltungen (ASIC), insbesondere innerhalb von Drucksensoren, entsprechenden Fügetechniken ausgesetzt werden, wobei eine Beschädigung des Mikrochips und/oder der darin enthaltenen Daten unterbleibt.

Um den erfindungsgemäßen Schutz vor der Einwirkung von UV-Strahlung bereitzustellen, kann die Schutzkomponente eine Filterung und/oder eine Streuung und/oder eine Reflexion und/oder eine Absorption von UV-Strahlung und/oder eine Umwandlung von UV-Strahlung in eine Strahlung höherer Wellenlänge bereitstellen. Eine Umwandlung in eine höhere Wellenlänge kann beispielsweise über einen Fluoreszenzeffekt stattfinden. Dabei fallen die angeregten Moleküle zunächst auf ein Zwischenniveau zurück und erst danach in den Grundzustand, wodurch das Fluoreszenzlicht um die so genannte Stokes-Verschiebung langwelliger wird. Das langwelligere Licht ist danach weniger energiereich und weist nicht mehr das unerwünschte zerstörerische Potenzial gegenüber Mikrochips auf. Alternativ oder zusätzlich kann auch eine so genannte Resonanzfluoreszenz ohne eine Wellenlängenänderung eintreten, welche sich jedoch wie eine verzögerte Streuwirkung auswirkt. Auch dadurch wird ein erfindungsgemäßer Schutz vor unerwünschter Einstrahlung von UV-Strahlung bewirkt. Dabei liegen Kombinationen der vorgenannten Wirkungen oder auch beliebige andere, nicht durch die vorgenannten spezifischen Effekte umfassten Wirkungen im Rahmen der Erfindung, solange die Schutzkomponente einen wirksamen Schutz vor der Einwirkung von UV-Strahlung bereitstellt.

Die Schutzkomponente kann gasförmig, flüssig, fest oder verformbar sein, und kann insbesondere thermoplastische und/oder elastische Eigenschaften aufweisen. Auch eine Kombination der vorgenannten Aggregatzustände oder die Kombination mehrerer Schutzkomponenten mit unterschiedlichen Aggregatzuständen und/oder plastischen und/oder elastischen Eigenschaften ist denkbar. Es ist vorteilhaft, wenn die Schutzkomponente gleichmäßig im Abdeckmaterial dispergiert ist, um einen ortsunabhängigen, definierten Schutz bereitzustellen.

Ein organischer Filter kann so beschaffen sein, dass dieser nur über einen begrenzten Zeitraum UV-Strahlung absorbiert und sich aufgrund der einwirkenden Strahlung zersetzt. Dementsprechend kann ein Abdeckmittel bereitgestellt werden, welches nach dem Abschluss eines vorgesehenen Folgeprozesses, bei dem UV-Strahlung einwirkt, keine oder nur noch geringe Mengen der Schutzkomponente aufweist.

Auf vorteilhafte Weise kann das Abdeckmaterial druckleitende Eigenschaften aufweisen. Dies erlaubt den Einsatz des erfindungsgemäßen Abdeckmaterials in Drucksensoren, nämlich insbesondere für den Fall, dass eine druckaufnehmende Membran des Sensors ebenfalls von dem Abdeckmaterial bedeckt wird. In praktischer Hinsicht kann das Abdeckmaterial für diesen Fall weich bzw. elastisch ausgebildet sein.

In einer weiteren vorteilhaften Weiterbildung weist das Abdeckmaterial neben der Schutzkomponente einen Zusatzstoff zur Neutralisierung von aggressiven Medien, insbesondere von Säuren, auf. Bei diesem Zusatzstoff kann es sich insbesondere um Calciumcarbonat und/oder um Calciumsulfat handeln. Der vorgeschlagene Zusatzstoff vermag einerseits aggressive Medien zu neutralisieren, welche auf die Oberfläche des Abdeckmittels einwirken. Dabei kann es sich insbesondere um Inhaltsstoffe von Flüssigkeiten oder Gasen handeln, deren Druck mittels eines Drucksensors aufgenommen wird, der mit einem erfindungsgemäßen Abdeckmittel bedeckt ist. Andererseits erweist sich diese Ausführung als besonders vorteilhaft im Hinblick auf den Einsatz von organischen Filtern als Schutzkomponente oder Teil einer Schutzkomponente, welche sich gegebenenfalls selber aufgrund der Einwirkung von UV-Strahlung in aggressive Medien, insbesondere in Säuren, zersetzen können. Mit dem vorgeschlagenen Zusatzstoff können solche innerhalb des Abdeckmaterials selbst entstehenden aggressiven Medien unmittelbar neutralisiert werden. Eine Beschädigung des Mikrochips durch von außen einwirkende und/oder innerhalb des Abdeckmaterials entstehende aggressiven Medien ist damit wirksam verhindert.

In vorteilhafter Weise kann das Abdeckmaterial einen Schutz von Dünndrahtbonds bereitstellen, welche mit dem Abdeckmaterial bedeckt sind. Dünndrahtbonds oder Bonddrähte sind bekannt, um beispielsweise Teile eines integrierten Schaltkreises oder eines diskreten Halbleiters mit elektrischen Anschlüssen zu verbinden. In vorteilhafter Weise kann durch das erfindungsgemäße Abdeckmittel neben dem Schutz eines Mikrochips auch ein - insbesondere mechanischer - Schutz der empfindlichen Dünndrahtbonds bereitgestellt werden. So lassen sich auch dünndrahtgebondete Mikrochips mit einer Deckschicht des erfindungsgemäßen Abdeckmaterials bereitstellen. Das erfindungsgemäße Abdeckmaterial stellt auch einen wirksamen Schutz, nämlich sowohl einen Schutz vor mechanischer Einwirkung als auch vor UV-Einstrahlung, beliebiger weiterer Komponenten eines Mikrochips oder beliebiger hiermit verbundener Anschlusselemente bereit.

Im Rahmen der Erfindung wird des Weiteren ein mit einem Abdeckmaterial bedeckter Mikrochip mit den Merkmalen des Anspruchs 8 vorgeschlagen. Danach ist ein eingangs genannter Mikrochip durch ein erfindungsgemäßes Abdeckmaterial weitergebildet. Eine vorteilhafte Ausgestaltung des Mikrochips ist dem hierzu nachgeordneten Anspruch entnehmbar.

In Bezug auf die Erläuterung des Wesens und der Vorteile des erfindungsgemäßen Mikrochips wird zunächst vollumfänglich auf die obigen Erläuterungen bezüglich des erfindungsgemäßen Abdeckmaterials verwiesen. Mit anderen Worten ergeben sich das Wesen und die Vorteile des erfindungsgemäßen Mikrochips bereits direkt aus den obigen Ausführungen bezüglich der Aspekte des erfindungsgemäßen Abdeckmaterials, auf die vollumfänglich Bezug genommen wird.

Außerdem wird betont, dass innerhalb des erfindungsgemäßen Mikrochips sämtliche Aspekte oder Kombinationen von Aspekten des oben beschriebenen Abdeckmaterials sowie diesbezüglicher vorteilhafter Weiterbildungen realisiert werden können, wodurch wiederum bevorzugte Weiterbildungen des erfindungsgemäßen Mikrochips erhalten werden. In Bezug auf Aspekte und Vorteile solcher Weiterbildungen wird daher ebenfalls auf die obigen Ausführungen verwiesen, auf die ausdrücklich Bezug genommen wird.

So kann der Mikrochip mit einem Abdeckmaterial bedeckt sein, in dem die Schutzkomponente eine Filterung und/oder eine Streuung und/oder eine Reflexion und/oder eine Absorption von UV-Strahlung bereitstellt.

Das den erfindungsgemäßen Mikrochip bedeckende Abdeckmaterial kann eine gasförmige, flüssige, feste oder verformbare Schutzkomponente aufweisen, und/oder kann eine Schutzkomponente aufweisen, welche gleichmäßig im Abdeckmaterial dispergiert ist.

Das Abdeckmaterial des erfindungsgemäßen Mikrochips kann eine Schutzkomponente mit einem organischen Filter, insbesondere einem Salicylsäureester, aufweisen, und/oder kann ein Pigment, insbesondere Titandioxid und/oder Zinkoxid, aufweisen.

Das Abdeckmaterial des Mikrochips kann druckleitende Eigenschaften aufweisen.

Insbesondere ist eine Weiterbildung des erfindungsgemäßen Mikrochips bevorzugt, nach der der Mikrochip einen Drucksensor aufweist oder Teil eines Drucksensors ist.

Das Abdeckmaterial auf dem vorgeschlagenen Mikrochip kann einen Zusatzstoff zur Neutralisierung von aggressiven Medien, insbesondere von Säuren, aufweisen, insbesondere wobei der Zusatzstoff Calciumcarbonat und/oder Calciumsulfat aufweisen kann.

In einer weiteren bevorzugte Ausführungsform des erfindungsgemäßen Mikrochips weist der Mikrochip Dünndrahtbonds auf, welche ebenfalls mit dem erfindungsgemäßen Abdeckmaterial bedeckt sind. Vorzugsweise sind die Dünndrahtbonds des Mikrochips dabei in das erfindungsgemäße Abdeckmaterial eingebettet. So ist ein hervorragender Schutz nicht nur des Mikrochips selber, sondern auch der Dünndrahtbonds vor mechanischen Einwirkungen und, falls erforderlich, auch vor der Einwirkung von UV-Strahlung realisiert.

Insbesondere ist eine Weiterbildung des erfindungsgemäßen Mikrochips bevorzugt, nach der der Mikrochip einen Drucksensor aufweist oder Teil eines Drucksensors ist.

Mit den Merkmalen des Anspruchs 10 wird schließlich ein Verfahren zur Bereitstellung eines mit einem Abdeckmaterial bedeckten Mikrochips vorgeschlagen.

Das Wesen und die Vorteile des vorgeschlagenen Verfahrens zur Bereitstellung eines mit einem Abdeckmaterial bedeckten Mikrochips ergeben sich dabei direkt aus den obigen detaillierten Ausführungen in Bezug auf das erfindungsgemäße Abdeckmaterial und/oder in Bezug auf den erfindungsgemäßen Mikrochip. Auf diese Ausführungen wird vollumfänglich Bezug genommen. Es sei darauf hingewiesen, dass innerhalb des erfindungsgemäßen Verfahrens jeder der oben erläuterten Aspekte oder jedwede Kombination von Aspekten des erfindungsgemäßen Abdeckmaterials bereitstellbar sind, wodurch automatisch vorteilhafte Ausgestaltungen des erfindungsgemäßen Verfahrens erhalten werden. Die so bereitstellbaren Vorteile des erfindungsgemäßen Verfahrens sowie dessen vorteilhafte Ausgestaltungen ergeben sich ebenfalls bereits aus den obigen Ausführungen, auf welche Bezug genommen wird.

### Kurze Beschreibung der Zeichnungen

Ausgangsbeispiele der Erfindung sind in den Zeichnungen dargestellt und werden im Folgenden näher erläutert. Es zeigen:
- Figur 1: in einer schematischen, seitlichen Schnittdarstellung einen Drucksensor mit zwei Exemplaren eines Ausführungsbeispiels eines erfindungsgemäßen Mikrochips, wobei beide Exemplare von einem erfindungsgemäßen Abdeckmaterial bedeckt sind,
- Figur 2: ebenfalls in einer schematischen Darstellung die Plasmavorbehandlung des Gehäuses des Drucksensors gemäß Fig. 1 zur Verklebung auf einem Stutzen,
- Figur 3: schematisch dargestellt die Verklebung eines Drucksensors gemäß Fig. 1 in einem weiteren Stutzen mittels Klebstoffvernetzung durch Einwirkung von UV-Strahlung, und
- Figur 4: in vier schematischen Einzeldarstellungen a) - d) die Darstellung bevorzugter Wirkungsweisen des erfindungsgemäßen Abdeckmaterials zum Entfalten eines Schutzes vor der Einwirkung von UV-Strahlung.

### Ausführungsformen der Erfindung

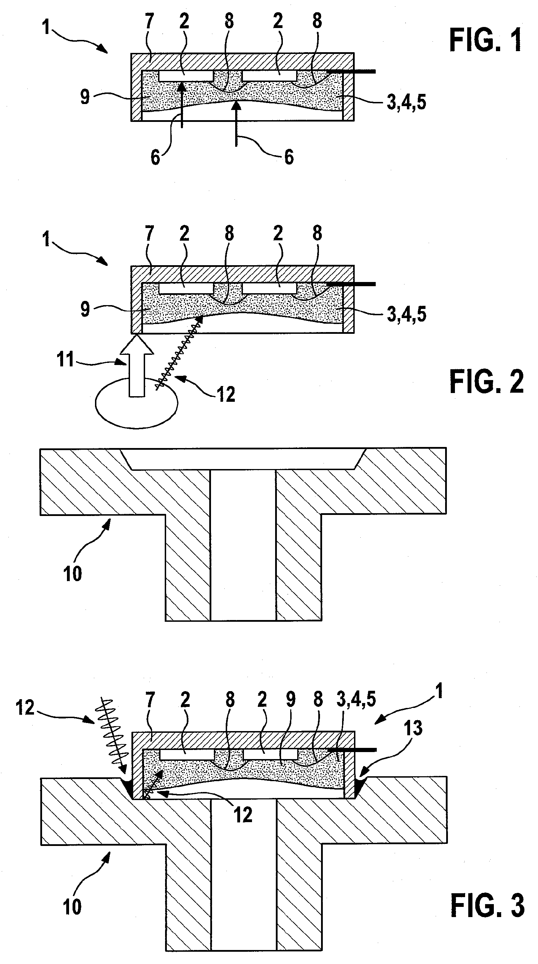

In Figur 1 ist in einer seitlichen Schnittdarstellung ein Drucksensor 1 gezeigt, welcher zwei Mikrochips 2 aufweist. Die Mikrochips 2 sind von einem erfindungsgemäßen Abdeckmaterial 3 bedeckt. Daher zeigt Fig. 1 sowohl ein Ausführungsbeispiel eines erfindungsgemäßen Abdeckmaterials 3 als auch ein Ausführungsbeispiel von zwei Exemplaren einer bevorzugten Ausführungsform des erfindungsgemäßen Mikrochips 2.

Das Abdeckmaterial 3 weist gemäß vorliegendem Ausführungsbeispiel ein Gel 4, nämlich ein Silikon-Gel 5, auf. Die gezeigten Mikrochips 2 umfassen ein Sensorelement, welches zumindest eine Membran zum Messen eines von außen auf den Drucksensor 1 wirkenden Druckes 6 aufweist.

Die beiden Mikrochips 2 sind am Boden eines Gehäuseteils 7 angeordnet, welches dem Drucksensor 1 zugeordnet ist.

Das Gehäuseteil 7 ist im vorliegenden Beispiel aus Kunststoffmaterial gefertigt. Die beiden Mikrochips 2 sind über Dünndrahtbonds 8 miteinander und auf die Außenseite des Drucksensors 1 führend verbunden, um eine Weiterleitung der aufgenommenen Messdaten zu ermöglichen.

Das erfindungsgemäße Abdeckmaterial 3 bedeckt die Mikrochips 2, oder, mit anderen Worten, die Mikrochips 2 sind in das erfindungsgemäße Abdeckmaterial 3 eingebettet. In erfindungsgemäßer Weise weist das Abdeckmaterial 3 nun zumindest eine Schutzkomponente 9 auf, welche einen Schutz der mit dem Abdeckmaterial 3 bedeckten Mikrochips 2 vor der Einwirkung von UV-Strahlung bereitstellt. Die Schutzkomponente 9 kann hierzu einen organischen Filter, insbesondere einen Salicylsäureester und/oder ein Pigment, insbesondere Titandioxid und/oder Zinkoxid, aufweisen, ist jedoch nicht auf diese Komponenten beschränkt. Vielmehr kann die Schutzkomponente 9 jeden Stoff aufweisen, welcher in erfindungsgemäßer Weise einen Schutz vor UV-Strahlung bereitzustellen vermag. Des Weiteren kann die Schutzkomponente 9 gasförmig, flüssig, fest oder verformbar sein. Vorzugsweise ist die Schutzkomponente 9 überdies gleichmäßig im Abdeckmaterial 3 dispergiert.

Im gezeigten Beispiel, nämlich bei einem Einsatz in dem Drucksensor 1, weist das Abdeckmaterial 3 druckleitende Eigenschaften auf, ist demnach durch eine gelartige, weiche oder elastische Konsistenz gekennzeichnet. Aufgrund dieser Verformbarkeit kann der von außen wirkende Druck 6 durch das Abdeckmaterial 3 bis auf die Oberfläche der Mikrochips 2 weitergeleitet werden.

Aufgrund der Einbettung der Mikrochips 2 und der Dünndrahtbonds 8 in dem erfindungsgemäßen Abdeckmaterial 3 stellt dieses nicht nur einen wirksamen Schutz vor UV-Strahlung bereit, sondern schützt sowohl die Mikrochips 2 als auch die Dünndrahtbonds 8 vor nachteiligen mechanischen Einwirkungen.

Figur 2 zeigt ebenfalls in einer schematischen Darstellung die Plasmavorbehandlung des Gehäuseteils 7 des Drucksensors gemäß Fig. 1 zur Verklebung auf einem Stutzen, nämlich einem weiteren Gehäuse 10.

Hier ist der in der Praxis verbreitet auftretende Fall schematisch dargestellt, wonach ein Mikrochip 2 mitsamt einem zugeordneten Gehäuseteil 7, in diesem Fall der Drucksensor 1 mit dem Gehäuseteil 7, mit einem weiteren Gehäuse 10 verbunden werden soll. Das weitere Gehäuse 10 besteht dabei ebenfalls aus Kunststoffmaterial und weist einen röhrenförmigen Stutzen mit Klebegeometrie auf, auf dem das Gehäuseteil 7, nämlich der Drucksensor 1, mittels einer Klebeverbindung befestigt werden soll. So kann im Endeffekt der Druck eines mit dem röhrenförmigen Stutzen des weiteren Gehäuses 10 korrespondierenden Mediums gemessen werden.

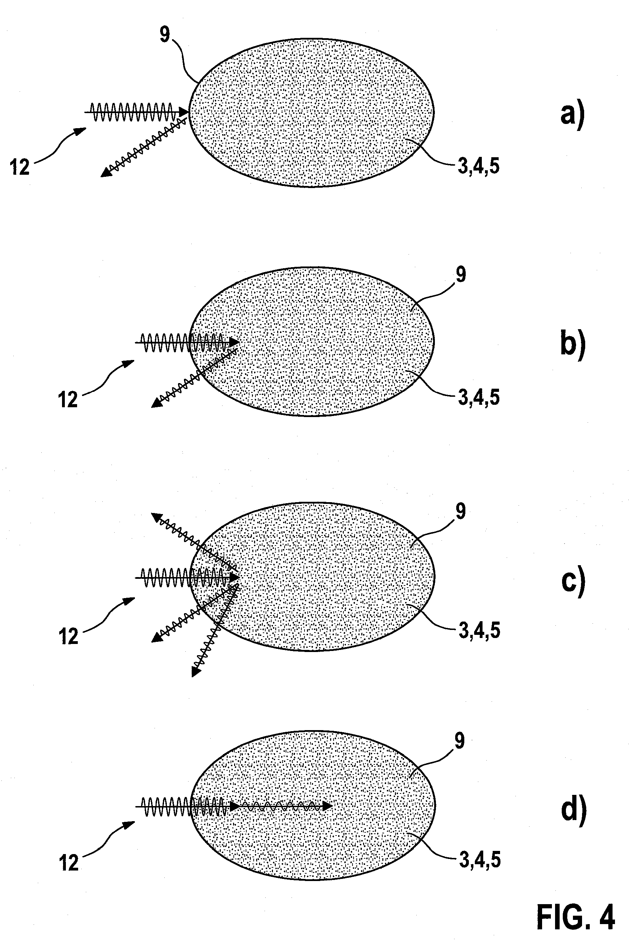

Um zwischen dem Gehäuseteil 7 und dem weiteren Gehäuse 10 eine Klebeverbindung mit ausreichender Stabilität und Haltbarkeit herzustellen, ist zu bevorzugen, zumindest die untere Stirnfläche des Gehäuseteils 7 zu aktivieren, nämlich durch eine Behandlung mit Plasma 11. Bei einer solchen Vorbehandlung mit Plasma 11 kann jedoch UV-Strahlung 12 freigesetzt werden, welche dann unerwünscht und in nachteiliger Weise (wie oben beschrieben) auf die Mikrochips 2 einwirken könnte. Aufgrund der erfindungsgemäß vorgesehenen Schutzkomponente 9 im Abdeckmaterial 3 und dem dadurch erhaltenen Schutz der erfindungsgemäßen Mikrochips 2 wird jedoch eine Schädigung der Mikrochips 2 durch die UV-Strahlung 12 vermieden. Verschiedene bereits erwähnte Wirkungsweisen der Schutzkomponente 9 gegen die UV-Strahlung 12 werden anhand von Fig. 4 bildlich erläutert. Im Allgemeinen ist entscheidend, dass die Schutzkomponente 9 die Einstrahlung von UV-Strahlung 12 auf einen Mikrochip 2 vollständig unterbindet, oder aber zumindest soweit reduziert, dass keine schadhaften Wirkungen in dem Mikrochip 2 eintreten können.

Figur 3 verdeutlicht in schematischer Weise einen weiteren verbreiteten Montagefall, bei dem unerwünscht UV-Strahlung 12 auf einen Mikrochip 2 einwirken kann. Hier wird zwischen dem Gehäuseteil 7 des Drucksensors 1 und dem weiteren Gehäuse 10 eine Klebeverbindung 13 ausgebildet. Bei dem für die Klebeverbindung 13 verwendeten Klebstoff handelt es sich um ein Produkt, bei dem die Vernetzung durch das Beaufschlagen mit UV-Strahlung 12 erfolgt. Dies ermöglicht neben einer sehr stabilen und haltbaren Klebeverbindung 13 eine schnelle Fixierung der Fügepartner und damit kurze Taktzeiten. Allerdings ist bei solchen Klebeprozessen eine vollständige Abschirmung der UV-Strahlung 12 von sensiblen Bereichen, nämlich insbesondere den Mikrochips 2, nicht immer möglich. Daher gelangt zumindest ein Anteil der angewendeten UV-Strahlung 12 in das Innere des Drucksensors 1. Aufgrund der im Abdeckmaterial 3 enthaltenen Schutzkomponente 9 kann jedoch auch in diesem Fall ein wirksamer Schutz der Mikrochips 2 und - soweit erforderlich - auch der Dünndrahtbonds 8 vor schadhafter UV-Strahlung 12 sichergestellt werden.

Figur 4 zeigt schließlich in vier schematischen Einzeldarstellungen gemäß Fig. 4 a) - d) besonders bevorzugte Wirkungsmechanismen des Abdeckmaterials 3 nach der Erfindung zum Schutz vor unerwünschter UV-Strahlung 12.

Die nachfolgend gemäß Fig. 4 a) - d) erläuterten, besonders bevorzugten Wirkmechanismen der Schutzkomponente 9 können dabei einzeln oder auch in beliebiger Kombination realisiert werden. Des Weiteren ist der Wirkmechanismus der Schutzkomponente 9 nicht auf einen oder mehrere der Mechanismen gemäß Fig. 4 beschränkt. Vielmehr kann die Schutzkomponente 9 in beliebiger Weise wirken, solange ein vorbeschriebener Schutz vor der Einwirkung von UV-Strahlung 12 bewirkbar ist.

In Fig. 4 a) wird durch die Schutzkomponente 9 bereits an der Oberfläche des Abdeckmaterials 3, nämlich des Gels 4, hier des Silikon-Gels 5, eine Reflexion der UV-Strahlung 12 bewirkt. Dazu kann die Schutzkomponente 9 dünne, insbesondere aufgedampfte, und insbesondere metallische Beschichtungen aufweisen. Alternativ oder zusätzlich kann die Schutzkomponente 9 reflektierende Partikel, insbesondere aus metallischen Werkstoffen, aufweisen.

Figur 4 b) zeigt schematisch dargestellt einen Wirkmechanismus, wonach die Schutzkomponente 9 ebenfalls reflektierende Partikel aufweist. In diesem Fall kann die UV-Strahlung 12 jedoch anfangs in das Abdeckmaterial 3 eindringen, wird jedoch im Inneren des Abdeckmaterials 3 durch die Schutzkomponente 9 reflektiert. Dementsprechend lassen sich die Wirkmechanismen gemäß a) und b) besonders bevorzugt kombinieren.

Alternativ oder zusätzlich zum Mechanismus gemäß Fig. 4 a) und/oder Fig. 4 b) kann die Schutzkomponente 9 Stoffe, Partikel, Tröpfchen oder Gaseinschlüsse aufweisen, welche die UV-Strahlung 12 streuen. Dieser Mechanismus ist in Fig. 4 c) schematisch dargestellt.

Dabei kann die Streuwirkung transparenter Grundmaterialien erhöht werden, wenn die Brechungsindizes der Materialien möglichst unterschiedlich gewählt werden.

Gemäß dem in Fig. 4 d) dargestellten weiteren Beispiel kann die Schutzkomponente 9 alternativ oder zusätzlich Stoffe aufweisen, welche die UV-Strahlung 12 vollständig absorbieren oder mit einer höheren Wellenlänge wieder abgeben. Letzterer Fall ist in d) dargestellt.

Dazu kann die Schutzkomponente 9 Filter, insbesondere organische Filter, und insbesondere Salicylsäureester-Verbindungen aufweisen. Alternativ oder zusätzlich können Mikropigmente, vorzugsweise fein verteilte Titandioxid- und/oder Zinkoxid-Partikel, Verwendung finden.

Aufgrund der Beaufschlagung des Abdeckmaterials 3 mit energiereicher UV-Strahlung 12 können im Abdeckmaterial 3 Zersetzungs- oder Umwandlungsprozesse eintreten. Insbesondere können sich genannte organische Filter unter der Einwirkung von UV-Strahlung 12 in aggressive, insbesondere saure oder Säure bildende Medien umwandeln, daher kann das Abdeckmaterial 3 Zusatzstoffe zur Neutralisierung solcher aggressiven Medien enthalten, und kann insbesondere Calciumcarbonat und/oder Calciumsulfat aufweisen.

## Patentansprüche

1. Abdeckmaterial (3) für einen Mikrochip (2) mit zumindest eine Schutzkomponente (9), welche einen Schutz eines mit dem Abdeckmaterial (3) bedeckten Mikrochips (2) vor der Einwirkung von UV-Strahlung (12) bereitstellt, **dadurch gekennzeichnet, dass** die Schutzkomponente (9) einen organischen Filter und ein Pigment aufweist, wobei der organische Filter ein Salicylsäureester ist und das Pigment Titandioxid und/oder Zinkoxid ist.

2. Abdeckmaterial (3) nach dem vorhergehenden Anspruch, **dadurch gekennzeichnet, dass** die Schutzkomponente (9) eine Filterung und/oder eine Streuung und/oder eine Reflexion und/oder eine Absorption von UV-Strahlung (12) und/oder eine Umwandlung von UV-Strahlung (12) in eine Strahlung höherer Wellenlänge bereitstellt.

3. Abdeckmaterial (3) nach einem der vorhergehenden Ansprüche, **dadurch gekennzeichnet, dass** die Schutzkomponente (9) gasförmig, flüssig, fest oder verformbar ist, und/oder dass die Schutzkomponente (9) gleichmäßig im Abdeckmaterial (3) dispergiert ist.

4. Abdeckmaterial (3) nach einem der vorhergehenden Ansprüche, **dadurch gekennzeichnet, dass** das Abdeckmaterial (3) druckleitende Eigenschaften aufweist.

5. Abdeckmaterial (3) nach einem der vorhergehenden Ansprüche, **gekennzeichnet durch** einen Zusatzstoff zur Neutralisierung von aggressiven Medien.

6. Abdeckmaterial (3) nach Anspruch 5, wobei der Zusatzstoff zur Neutralisierung von Säuren ist.

7. Abdeckmaterial (3) nach Anspruch 5, wobei der Zusatzstoff Calciumcarbonat und/oder Calciumsulfat aufweist.

8. Abdeckmaterial (3) nach einem der vorhergehenden Ansprüche, **dadurch gekennzeichnet, dass** das Abdeckmaterial (3) einen Schutz von Dünndrahtbonds (8) bereitstellt, welche mit dem Abdeckmaterial (3) bedeckt sind.

9. Mikrochip (2), welcher mit einem Abdeckmaterial (3) bedeckt ist, **gekennzeichnet durch** ein Abdeckmaterial (3) nach einem der vorhergehenden Ansprüche.

10. Mikrochip (2) nach dem vorhergehenden Anspruch, **dadurch gekennzeichnet, dass** der Mikrochip (2) einen Drucksensor (1) aufweist oder Teil eines Drucksensors (1) ist.

11. Verfahren zur Bereitstellung eines mit einem Abdeckmaterial (3) bedeckten Mikrochips (2), wobei das Verfahren die Schritte aufweist
- Bereitstellung eines Mikrochips (2),
- Bereitstellung eines Abdeckmaterials (3) nach einem der Ansprüche 1 bis 8,
- Bedecken des Mikrochips (2) mit dem Abdeckmaterial (3).

12. Abdeckmaterial nach einem der Ansprüche 1 bis 18, **dadurch gekennzeichnet, dass** das Abdeckmaterial ein Abdeckmaterial auf der Basis von Gel ist.

## Claims

1. Covering material (3) for a microchip (2) comprising at least one protective component (9) which provides protection of a microchip (2) covered by the covering material (3) against the effect of UV radiation (12), **characterized in that** the protective component (9) comprises an organic filter and a pigment, wherein the organic filter is a salicylic ester and the pigment is titanium deoxide and/or zinc oxide.

2. Covering material (3) according to the preceding claim, **characterized in that** the protective component (9) provides a filtering and/or a scattering and/or a reflection and/or an absorption of UV radiation (12) and/or a conversion of UV radiation (12) into a radiation having a higher wavelength.

3. Covering material (3) according to either of the preceding claims, **characterized in that** the protective component (9) is gaseous, liquid, solid or deformable, and/or **in that** the protective component (9) is dispersed uniformly in the covering material (3).

4. Covering material (3) according to any of the preceding claims, **characterized in that** the covering material (3) has pressure-conducting properties.

5. Covering material (3) according to any of the preceding claims, **characterized by** an additive for neutralising aggressive media.

6. Covering material (3) according to Claim 5, wherein the additive is for neutralising acids.

7. Covering material (3) according to Claim 5, wherein the additive comprises calcium carbonate and/or calcium sulphate.

8. Covering material (3) according to any of the preceding claims, **characterized in that** the covering material (3) provides protection of thin wire bonds (8) that are covered by the covering material (3).

9. Microchip (2) covered by a covering material (3), **characterized by** a covering material (3) according to any of the preceding claims.

10. Microchip (2) according to the preceding claim, **characterized in that** the microchip (2) comprises a pressure sensor (1) or is part of a pressure sensor (1).

11. Method for providing a microchip (2) covered by a covering material (3), wherein the method comprises the following steps:
- providing a microchip (2),
- providing a covering material (3) according to any of Claims 1 to 8,
- covering the microchip (2) with the covering material (3).

12. Covering material according to any of Claims 1 to 18, **characterized in that** the covering material is a covering material on the basis of gel.

## Revendications

1. Matériau de recouvrement (3) pour une micropuce (2), comprenant au moins un composant protecteur (9), qui assure une protection d'une micropuce (2), recouverte du matériau de recouvrement (3), contre l'effet d'un rayonnement UV (12), **caractérisé en ce que** le composant protecteur (9) comprend un filtre organique et un pigment, le filtre organique étant un ester de l'acide salicylique et le pigment étant le dioxyde de titane et/ou l'oxyde de zinc.

2. Matériau de recouvrement (3) selon la revendication précédente, **caractérisé en ce que** le composant protecteur (9) assure une filtration et/ou une diffusion et/ou une réflexion et/ou une absorption du rayonnement UV (12) et/ou une conversion du rayonnement UV (12) en un rayonnement de longueur d'onde plus grande.

3. Matériau de recouvrement (3) selon l'une des revendications précédentes, **caractérisé en ce que** le composant protecteur (9) est gazeux, liquide, solide ou déformable, et/ou que le composant protecteur (9) est uniformément dispersé dans le matériau de recouvrement (3).

4. Matériau de recouvrement (3) selon l'une des revendications précédentes, **caractérisé en ce que** le matériau de recouvrement (3) présente des propriétés conductrices de pression.

5. Matériau de recouvrement (3) selon l'une des revendications précédentes, **caractérisé par** un additif pour la neutralisation de milieux agressifs.

6. Matériau de recouvrement (3) selon la revendication 5, dans lequel l'additif sert à la neutralisation d'acides.

7. Matériau de recouvrement (3) selon la revendication 5, dans lequel l'additif comprend du carbonate de calcium et/ou du sulfate de calcium.

8. Matériau de recouvrement (3) selon l'une des revendications précédentes, **caractérisé en ce que** le matériau de recouvrement (3) assure une protection de fils minces de connexion (8) qui sont recouverts du matériau de recouvrement (3).

9. Micropuce (2), qui est recouverte d'un matériau de recouvrement (3), **caractérisée par** un matériau de recouvrement (3) selon l'une des revendications précédentes.

10. Micropuce (2) selon la revendication précédente, **caractérisée en ce que** la micropuce (2) comprend un capteur de pression (1) ou est une partie d'un capteur de pression (1).

11. Procédé pour mettre à disposition une micropuce (2) recouverte d'un matériau de recouvrement (3), le procédé comprenant les étapes :
- mise à disposition d'une micropuce (2)
- mise à disposition d'un matériau de recouvrement (3) selon l'une des revendications 1 à 8,
- recouvrement de la micropuce (2) avec le matériau de recouvrement (3).

12. Matériau de recouvrement selon l'une des revendications 1 à 18, **caractérisé en ce que** le matériau de recouvrement est un matériau de recouvrement à base d'un gel.
